Europäisches Patentamt

European Patent Office

Office européen des brevets

(19)

(11) **EP 0 468 886 B1**

(12)

# FASCICULE DE BREVET EUROPEEN

(45) Date de publication et mention
de la délivrance du brevet:
**02.09.1998 Bulletin 1998/36**

(51) Int Cl.⁶: **H05H 1/46**

(21) Numéro de dépôt: **91402057.3**

(22) Date de dépôt: **24.07.1991**

(54) **Dispositif de production d'un plasma**

Einrichtung zum Erzeugen eines Plasmas

Plasma production device

(84) Etats contractants désignés:
**AT BE CH DE DK ES FR GB GR IT LI LU NL SE**

(30) Priorité: **27.07.1990 FR 9009618**

(43) Date de publication de la demande:
**29.01.1992 Bulletin 1992/05**

(73) Titulaire: **ATEA SOCIETE ATLANTIQUE DE
TECHNIQUES AVANCEES
44472 Carquefou Cédex (FR)**

(72) Inventeurs:
• **Dessaux, Odile**
  **F-59800 Lille (FR)**
• **Dupret, Christian**
  **F-59110 La Madeleine (FR)**
• **Goudmand, Pierre**
  **F-59800 Lille (FR)**
• **Hoyez, Christophe**
  **F-59112 Carnin (FR)**

(74) Mandataire: **Derambure, Christian et al
Bouju Derambure Bugnion
52, rue de Monceau
75008 Paris (FR)**

(56) Documents cités:
EP-A- 321 792        WO-A-88/10506
DE-U- 8 628 306      FR-A- 2 074 715
FR-A- 2 290 126      FR-A- 2 616 030

## Description

L'invention concerne un dispositif de production d'un plasma comprenant une cavité délimitée par une paroi extérieure métallique et traversée par un tube de décharge dans lequel circule un gaz plasmagène, un générateur de micro-ondes et des moyens de transport des micro-ondes entre la sortie du générateur et l'intérieur de la cavité.

Ce dispositif constitue un coupleur micro-ondes/plasma pour produire un plasma froid par résonance forcée d'ondes électromagnétiques dans la gamme des hyperfréquences.

Dans les coupleurs connus pour la production de plasma, la cavité résonante a une forme cylindrique ou parallélépipédique. Dans des réalisations, les ondes produites par le générateur sont transportées vers la cavité par un guide d'ondes dimensionné en fonction de la longueur d'onde des ondes à transmettre. Entre le guide d'ondes et la cavité est disposé un orifice équipé de vis de réglage dit iris, pour "accorder" le coupleur, c'est-à-dire maximiser le rapport de l'énergie transmise au plasma à l'énergie délivrée par le générateur. La cavité est dimensionnée en fonction de la longueur d'onde, de façon à former des ondes stationnaires. La géométrie du système est prévue pour que le gaz plasmagène circule dans la cavité, à un endroit où le champ électrique est le plus élevé, afin que l'énergie communiquée au gaz plasmagène soit importante.

Ces coupleurs souffrent d'une limitation de la puissance de sortie du plasma. Dans l'exemple d'un plasma d'azote, il semble impossible de dépasser une puissance de 800 W, même avec un générateur de micro-ondes de 6 kW. En conséquence, pour de nombreuses applications requérant des plasmas très énergétiques, plusieurs coupleurs et plusieurs générateurs sont à prévoir, ce qui est compliqué. En outre, il n'est souvent pas possible de disposer plusieurs coupleurs car la cavité et le guide d'ondes ont des dimensions supérieures à la longueur d'one des micro-ondes (décimétrique), ce qui est trop encombrant.

En outre, l'iris et le dispositif de réglage nécessitent de nombreuses manipulations, assez mal adaptées à une utilisation industrielle.

D'après le document FR-A-2 074 715, les micro-ondes sont transportées entre le générateur et la cavité au moyen d'un câble coaxial. Ces câbles ne permettent pas de véhiculer des densités d'énergie importantes en raison de la tenue insuffisante du diélectrique intercalaire soumis à un champ électrique intense. En pratique, les coupleurs décrits dans ce document sont limités à une puissance incidente de l'ordre de 800 W. Les coupleurs à câbles coaxiaux sont donc peu appropriés à la production de plasmas très énergétiques, typiquement plus de 1 kW.

Citons d'autres documents.

Le document WO-A-88/10506 décrit un générateur de plasma à symétrie d'axe, avec des moyens d'introduction de micro-ondes dans un guide-d'ondes et des moyens de réglage du champs micro-ondes, pour obtenir dans une chambre à vide, des strates d'ondes parallèles.

Le document EP-A-321 792 décrit une cavité résonante pour une source de lumière spectroscopique.

Le but de l'invention est de remédier à ces inconvénients, en proposant un dispositif simple et permettant d'engendrer un plasma très énergétique en optimisant le rapport de la puissance transmise au plasma à la puissance de sortie du générateur.

L'invention vise un dispositif de production d'un plasma tel que défini dans les revendications.

Ce dispositif comprend une cavité délimitée par une paroi extérieure métallique et traversée par un tube de décharge dans lequel circule en service un gaz plasmagène, un générateur de micro-ondes et des moyens de transport des micro-ondes entre la sortie du générateur et l'intérieur de la cavité.

Les moyens de transport des micro-ondes comprennent un guide d'ondes et une antenne en forme de tige métallique s'étendant entre l'intérieur du guide d'ondes et l'intérieur de la cavité.

Grâce à ce dispositif, le transport des micro-ondes est rendu possible par un agencement guide d'ondes/antenne, d'une grande simplicité par rapport aux coupleurs à guide d'ondes connus, qui ne l'obtenaient pas à cause de l'obligation d'utiliser un iris et un dispositif de réglage associé.En outre, cet angencement minimise les pertes de puissance au niveau de la transition vers la cavité, ce qui permet d'atteindre de très fortes valeurs de puissance transmise au gaz plasmagène. Cette transition n'imposa pas la présence d'éléments diélectriques qui, dans les coupleurs connus à câble coaxial, limitent considérablement les puissances incidentes possibles.

Dans une version de l'invention, le gaz plasmagène circulant dans le tube de décharge est exposé aux ondes transmises à l'intérieur de la cavité sur une longueur le long du tube de décharge réduite par rapport à la dimension de la cavité parallèlement à la direction du tube de décharge.

Grâce à un tel dispositif, la demanderesse a observé des puissances de plasma largement supérieures à celles rencontrées avec les coupleurs classiques. Dans l'exemple d'un plasma d'azote, on parvient ainsi à des puissances transmises de plusieurs kilowatts alors qu'un coupleur classique est limité à environ 800 W. Sans vouloir être liée par son interprétation, la demanderesse estime que ce gain de puissance vient du fait qu'une forte densité d'énergie se crée dans la zone où le gaz plasmagène est exposé au champ électromagnétique, ce qui favorise l'excitation des molécules ou atomes du gaz et du fait que cette excitation a lieu sur une longueur réduite du tube de décharge de sorte que les molécules ou atomes excités sont évacués rapidement de la zone d'exposition, évitant ainsi la réflexion du rayonnement micro-ondes sur des particules déjà excitées.

Dans un mode de réalisation, le dispositif comprend un segment tubulaire métallique situé à l'intérieur de la cavité et raccordé à la paroi extérieure de la cavité autour d'une zone où le tube de décharge traverse ladite paroi extérieure. Ce segment tubulaire entoure le tube de décharge sauf en une zone de longueur réduite par rapport à la dimension de la cavité parallèlement à la direction du tube de décharge.

Cela engendre un effet capacitif entre l'extrémité du segment tubulaire métallique et la partie de la paroi extérieure de la cavité qui fait face à cette extrémité. Cette capacité est le siège d'un champ électrique intense favorisant l'excitation du gaz.

D'autres particularités et avantages de l'invention apparaissent dans la description qui se réfère aux dessins illustrant des exemples de mise en oeuvre. Dans ces dessins :

- la figure 1 est une vue en coupe d'un dispositif conforme à l'invention prise selon le plan A-A de la figure 2 ;
- la figure 2 est une vue en coupe analogue à la figure 1, prise selon le plan B-B de la figure 1 ;
- la figure 3 illustre un détail de la figure 2;
- les figures 4 à 6 sont des vues en coupe de détails de variantes du dispositif illustré aux figures 1 à 3.

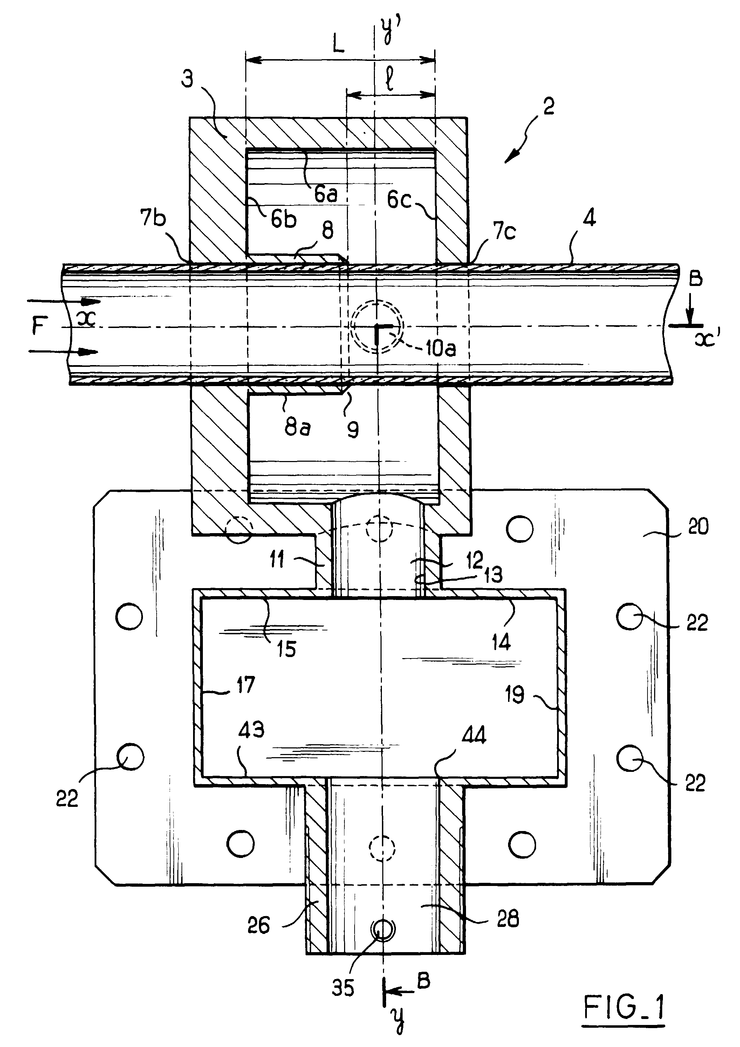

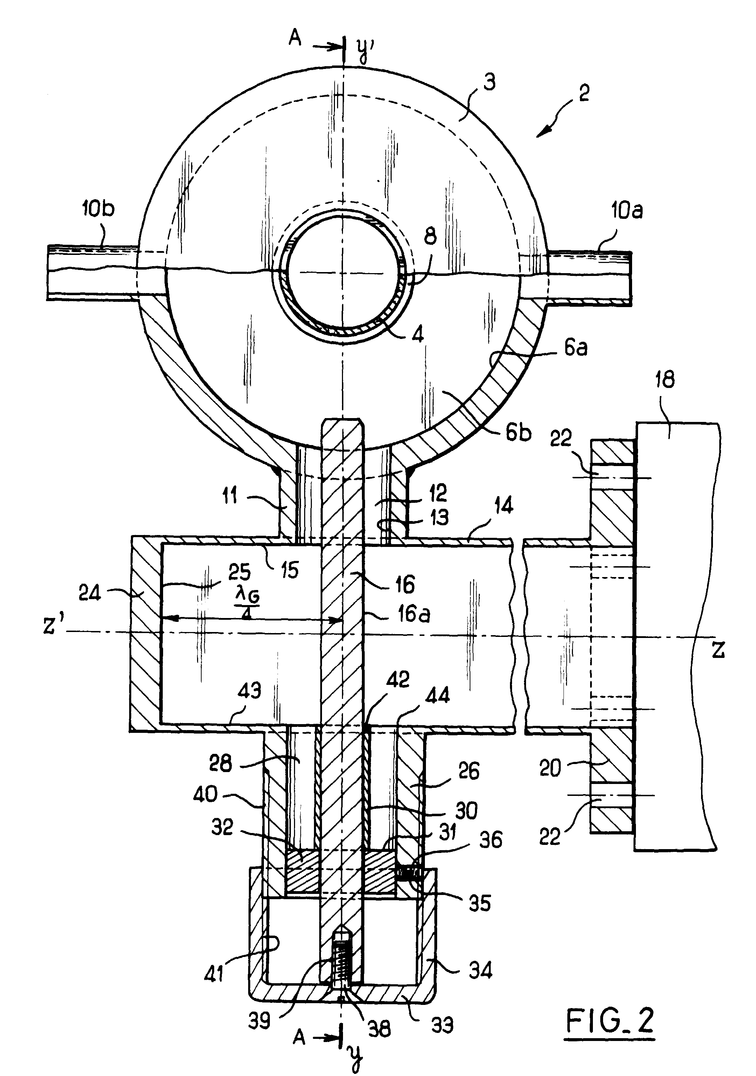

Comme illustré aux figures 1 et 2, l'exemple de dispositif conforme à la présente invention comporte une cavité 2 délimitée par une paroi extérieure métallique 3. Un tube cylindrique en quartz 4, dit tube de décharge, traverse la cavité 2 selon un axe x-x'. Un gaz plasmagène, comme par exemple de l'oxygène ou de l'azote, s'écoule dans le tube 4 dans le sens indiqué par les flèches F. Ce sens pourrait d'ailleurs être inversé sans perdre les effets recherchés par l'invention.

La paroi extérieure 3 de la cavité 2 a une forme cylindrique dans l'exemple illustré. Elle définit, à l'intérieur de la cavité 2, une surface périphérique 6a de révolution autour de l'axe x-x' du tube de décharge 4 et deux surfaces transversales 6b, 6c comprenant deux orifices 7b, 7c prévus pour laisser passer le tube de décharge 4.

A l'intérieur de la cavité 2, un segment tubulaire métallique 8 entoure une partie du tube de décharge 4. Le segment tubulaire 8 a une section cylindrique et un diamètre intérieur légèrement supérieur au diamètre extérieur du tube de décharge 4. Le segment tubulaire 8 se raccorde à la paroi extérieure 3 sur une de ses surfaces transversales 6b autour de l'orifice 7b présent dans cette surface 6b pour laisser passer le tube de décharge 4. L'autre extrémité 9 du segment tubulaire 8 est située en face de l'autre surface transversale 6c de la cavité 2, à une distance l de celle-ci. Ainsi, le gaz s'écoulant dans le tube 4 n'est exposé aux champs électromagnétiques transmis dans la cavité 2 que sur une zone d'exposition de longueur l parallèlement à la direction x-x' du tube de décharge 4, c'est-à-dire une longueur l réduite par rapport à la dimension L de la cavité 2 parallèlement à la direction x-x'. La longueur axiale L ci-dessus est prise entre les surfaces transversales 6b, 6c de la cavité 2. Comme on le voit sur la vue en coupe de la figure 1, la surface extérieure 8a du segment tubulaire 8 présente au voisinage de son extrémité libre 9, une forme tronconique de sorte que le chant du segment 8 à l'extrémité 9 comporte un biseau.

Deux conduits 10a, 10b débouchant dans la surface périphérique 6a de la cavité sont reliés à un dispositif de pompage, non représenté, destiné à faire circuler de l'air comprimé dans la cavité 2 afin de refroidir la cavité 2 et le tube de décharge 4 en fonctionnement.

Un générateur de micro-ondes 18 délivre des micro-ondes de fréquence prédéterminée. Le générateur 18 peut être un générateur usuel à magnétron.

Un guide d'ondes 14 et une antenne 16 assurent le transport des micro-ondes entre la sortie du générateur 18 et l'intérieur de la cavité 2. Le guide d'ondes 14 s'étend dans une direction z-z' représentée en traits mixtes à la figure 2 et présente une section rectangulaire définie par quatre surfaces 15, 17, 19, 43. Il est fixé au générateur 18 par des vis (non représentées) traversant des trous 22 prévus sur une embase 20. Une paroi 24 marque l'extrémité du guide d'ondes 14, définissant, à l'intérieur, une surface d'extrémité 25. Bien entendu, le guide d'ondes 14 est dimensionné, de façon classique, en fonction de la longueur d'onde des micro-ondes à transmettre. Il est à noter que la longueur d'onde $\lambda_G$ des micro-ondes dans le guide d'ondes 14 diffère de la longueur d'onde $\lambda_V$ des mêmes micro-ondes dans le vide. Des valeurs numériques typiques sont, pour un rayonnement micro-ondes de fréquence 2450 MHz, $\lambda_V = 12,24$ cm et $\lambda_G = 17,2$ cm.

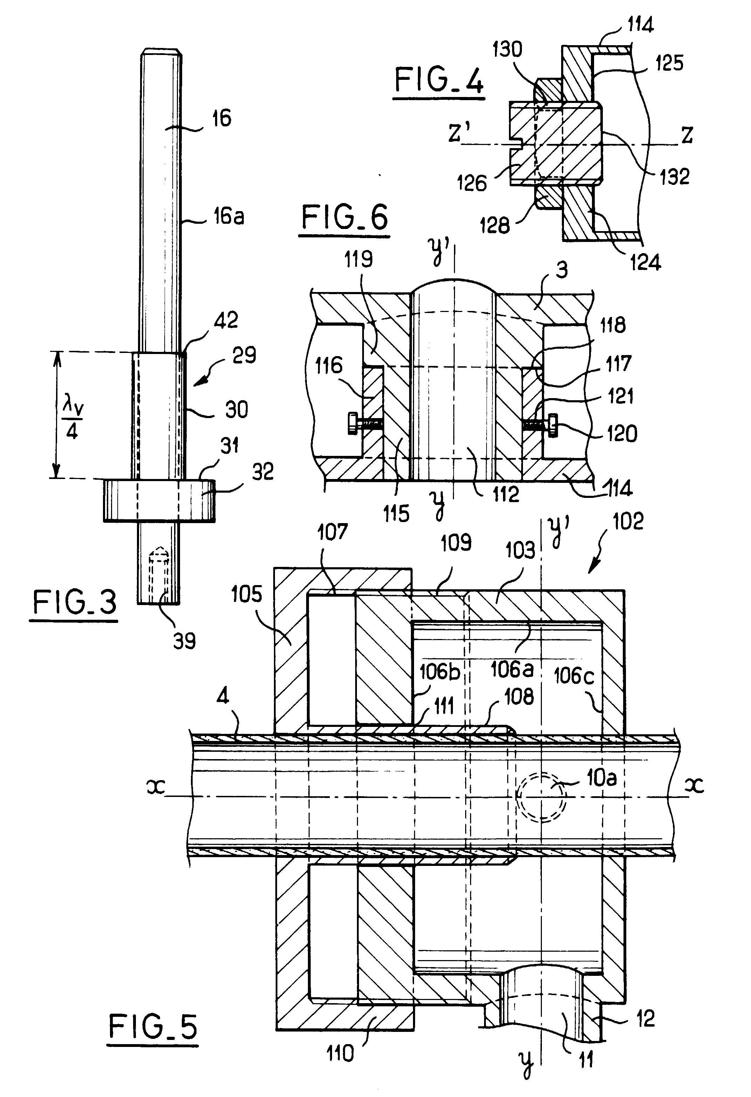

L'antenne représentée aux figures 2 et 3 est une tige métallique traversant le guide d'ondes 14 transversalement à sa direction z-z' et débouchant à l'intérieur de la cavité 2. La surface 16a de l'antenne 16 a une forme cylindrique. L'antenne 16 définit ainsi une direction y-y' perpendiculaire à la fois aux directions x-x' du tube de décharge 4 et z-z' du guide d'ondes 14. Les directions x-x' et y-y' sont concourantes. De même, les directions y-y' et z-z' sont concourantes.

L'axe y-y' de l'antenne 16 est situé, par rapport à la surface d'extrémité 25 du guide d'ondes 14 à une distance égale à $\lambda_G/4$, de façon à maximiser l'amplitude du champ électrique sur l'antenne lorsque les micro-ondes sont produites.

Entre le guide d'ondes 14 et la cavité 2, l'antenne 16 passe à travers un canal 12 délimité par une paroi cylindrique métallique 11. Le canal 12 débouche d'une part sur une surface 15 du guide d'ondes 14 et d'autre part sur la surface périphérique 6a de la cavité 2.

Du côté opposé à la cavité 2 par rapport au guide d'ondes 14, l'antenne 16 en forme de tige métallique se prolonge dans un espace 28 délimité par une paroi cylindrique métallique 26. Le passage 28 débouche dans le guide d'ondes 14 sur sa surface 43 opposée à la surface 15 comportant le canal 12.

Dans le passage 28, l'antenne 16 est montée coulissante dans un organe coaxial métallique 29.

L'organe 29 comprend un manchon 30, de longueur $\lambda_V/4$ entourant l'antenne 16 et une bague 32 dont le diamètre extérieur est légèrement inférieur au diamètre intérieur du passage 28 pour permettre la mise en place de l'organe 29 dans le passage 28. Lorsque l'organe coaxial 29 est monté dans le passage 28, la surface 31 formant épaulement entre le manchon 30 et la bague 32 constitue la surface d'extrémité du passage 28. On règle la position de l'organe 29 pour que l'extrémité 42 du manchon 30 opposée à la bague 32 se situe sensiblement dans le plan défini par la surface 43 du guide d'ondes où débouche le passage 28 au niveau de l'angle 44 entre la surface 43 et la surface intérieure de la paroi cylindrique 26. L'organe 29 est alors bloqué en mettant en place une cale 36. La cale 36 peut consister en une vis sans tête 36 engagée dans un trou taraudé 35 ménagé dans la paroi cylindrique 26 du passage 28.

Dans la version préférée de l'invention illustrée à la figure 2, l'antenne 16 peut coulisser le long de son axe y-y' dans le manchon 30 de façon à régler la longueur de pénétration de l'antenne 16 dans la cavité 2. A cet effet, une molette 33 est fixée à l'antenne 16, par exemple par une vis 38 engagée dans un trou taraudé 39 ménagé à l'extrémité de l'antenne 16. La molette 33 comprend une couronne cylindrique 34 dont la surface intérieure comporte un taraudage 41 destiné à venir en prise sur un filetage complémentaire 40 prévu sur la surface extérieure de la paroi 26 délimitant le passage 28.

Pour faire fonctionner le coupleur décrit ci-dessus, on alimente le générateur de micro-ondes 18, on fait circuler le gaz plasmagène dans le tube de décharge 4 par un dispositif de pompage, et on refroidit par air comprimé la cavité 2 et le tube de décharge 4 via les conduits 10a, 10b. Les micro-ondes produites sont alors transmises via le guide d'ondes 14. Comme l'axe de l'antenne 16 est situé à une distance égale au quart de la longueur d'onde $\lambda_G$ des micro-ondes dans le guide d'ondes 14, l'antenne 16 se trouve sur un ventre d'amplitude du champ électrique et elle transmet donc un champ électrique intense en direction de la cavité résonante 2. Ce champ électrique transmis donne lieu à des ondes stationnaires à l'intérieur de la cavité 2. Ces ondes stationnaires engendrent notamment un champ électrique très intense dans la zone d'exposition de longueur réduite l. La forte amplitude du champ électrique dans cette zone provient d'un effet capacitif entre l'extrémité 9 du segment tubulaire 8 et la surface transversale 6c de la cavité 2 qui lui fait face. L'intensité du champ est encore augmentée par la forme biseautée du chant du segment tubulaire 8 qui engendre un effet de pointe de nature à accroître l'amplitude du champ électrique.

L'application d'un champ électrique élevé excite les atomes ou molécules du gaz plasmagène circulant dans le tube de décharge 4 pour engendrer le plasma.

Les pertes électriques sont réduites en utilisant pour les éléments du dispositif venant en contact avec les micro-ondes (guide d'ondes 14, antenne 16, parois 11 et 3, segment tubulaire 8) un matériau, métal ou alliage métallique, bon conducteur électrique. Le laiton est un exemple utilisé par la demanderesse dans ses essais. Le rendement peut être encore amélioré en dorant les surfaces 6a, 6b, 6c, 8a, 13, 15, 16a, 17, 19, 26, 30, 31, 43, en contact avec les micro-ondes, ou certaines d'entre elles.

L'organe 29 coaxial à l'antenne 16 et disposé dans le passage 28 a pour effet d'annuler les fuites par le passage 28. En effet, comme une distance de $\lambda_V/4$ sépare la surface 31 formant extrémité du passage 28 et l'autre extrémité 42 du manchon 30, il se forme une impédance infinie entre cette extrémité 42 et l'angle 44 formé par la surface 43 du guide d'onde 14 et la surface intérieure du passage 28. Cette impédance infinie empêche tout courant de fuite par le passage 28 et évite ainsi la formation d'arcs électriques entre l'antenne 16 et l'extrémité 42 du manchon 30. Par ailleurs, ceci permet à l'utilisateur de manipuler la molette 33 sans s'exposer aux forts potentiels de fonctionnement. L'organe 29 entraîne donc que le perçage formé par le passage 28 dans la surface 43 du guide d'ondes 14 est "vu" par le champ électromagnétique comme équivalent à une impédance infinie. Il faut noter que cette isolation est réalisée sans utilisation d'éléments diélectriques (PTFE ou analogue) dont la tenue sous un fort champ électrique est souvent insuffisante.

Le réglage de l'antenne 16 par coulissement le long de son axe y-y' permet d'accorder la cavité résonante. Cet accord consiste à minimiser le taux d'ondes stationnaires TOS, défini par la formule:

$$\frac{P_R}{P_I} = \left( \frac{TOS - 1}{TOS + 1} \right)^2 \qquad (11)$$

où $P_R$ désigne la puissance réfléchie par le plasma et $P_I$ la puissance incidente de sortie du générateur. La puissance réfléchie est la puissance qui n'est pas transmise au plasma. Dans la présente invention, le coulissement de l'antenne 16 modifie la géométrie des lignes de champ à l'intérieur de la cavité 2 car il modifie la longueur de pénétration de l'antenne 16 dans la cavité 2. Une position optimale existe pour minimiser le TOS; l'accord consiste à rechercher cette position.

Grâce à ce dispositif, la demanderesse a obtenu des résultats très satisfaisants du point de vue du TOS, que les coupleurs de la technique antérieure ne permettaient pas d'atteindre.

Des exemples sont donnés au tableau I dans le cas d'un plasma d'azote pour différentes pressions de travail dans le tube de décharge 4, différents débits d'azote dans le tube 4 et différentes puissances incidentes. Des essais effectués à débit plus faible avec de l'oxygène ont donné des résultats analogues.

TABLEAU I

| Pression de travail (mbar) | Débit de gaz (1/mn ) | Puissance incidente (kW) | Puissance réfléchie (kW) |
|---|---|---|---|
| 10 | 10 à 55 | 0 à 6 | 0 |
| 50 | 10 à 100 | 0 à 6 | 0 |
| 100 | 10 à 100 | 0 à 6 | 0 |

On pense que le rendement excellent du coupleur, donnant une puissance réfléchie, sensiblement nulle, ou un TOS sensiblement égal à 1, est dû notamment à la nature de la transition, par guide d'ondes et antenne, et aussi au fait que les molécules de gaz sont excitées, en champ intense, sur une longueur $l$ du tube de décharge réduite par rapport à la dimension $L$ de la cavité.

Le diamètre du tube de décharge 4 est optimisé pour la cavité décrite mais peut être modifié de façon connue avec paramètres du calcul théorique des dimensions de la cavité 2 pour une fréquence donnée.

Le refroidissement par air comprimé de la cavité 2 du tube de décharge 4 compense l'échauffement dû au fonctionnement à haute puissance et prolonge ainsi la durée de vie de ces composants.

L'accord du coupleur par la molette 33 a bien entendu un caractère optionnel dans le cadre de la présente invention. Notamment, si le coupleur est destiné à une application unique, avec un seul gaz plasmagène, il peut être intéressant de supprimer le bouton de réglage 33. Le coupleur est, dans ce cas, accordé une fois pour toutes et le réglage ne peut pas être perdu.

Au contraire, pour d'autres applications, il peut s'avérer intéressant de disposer d'autres réglages pour optimiser les performances du dispositif. Des exemples sont illustrés aux figures 4 à 6.

La figure 4 est une coupe partielle de la zone d'extrémité du guide d'ondes 114 utilisé dans un coupleur conforme à l'invention. Une vis de réglage 126 est engagée dans un trou taraudé ménagé dans la paroi d'extrémité 124 du guide d'ondes 114. La vis 126 a une extrémité plane 132 qui se déplace parallèlement à l'axe z-z' du guide d'ondes 114 lorsqu'on serre ou desserre la vis de réglage 126. Ainsi, la surface 132 forme surface d'extrémité du guide d'ondes 114 pouvant être réglée pour être située en avant ou en retrait par rapport à la surface 125 en avant ou en retrait par rapport à la surface 125 de la paroi d'extrémité 124. Ce réglage permet d'optimiser la distance entre la surface d'extrémité 132 du guide d'ondes 114 et l'axe y-y' de l'antenne 16, cette distance devant être sensiblement égale à $\lambda_G /4$. Un contre-écrou 128 engagé sur le même pas de vis 130 de la vis 126 permet de bloquer la vis de réglage 126.

La figure 5 représente en coupe longitudinale une cavité 102 comportant un réglage de la distance $l$ entre l'extrémité du segment tubulaire 108 et la surface intérieure 106c de la cavité 102 qui lui fait face. La paroi extérieure 103 de cette cavité 102 diffère par rapport à la paroi extérieure 3 de la cavité 2 représentée à la figure 1 en ce que le trou 111 présent dans la surface transversale 106b adjacente au segment tubulaire 108 a une section légèrement supérieure à la section du trou analogue 7b dans la surface 6b à la figure 1. Ainsi le segment tubulaire 108 peut coulisser dans le trou 111 autour du tube de décharge 4. Ceci permet un réglage de la longueur $l$ de la zone d'exposition du gaz plasmagène aux champs électromagnétiques. Dans l'exemple représenté à la figure 5, le segment tubulaire 108 fait partie d'un organe de réglage 105 métallique (laiton). Cet organe 105 est de révolution autour de l'axe x-x' du tube de décharge 4 et monté autour de ce dernier. L'organe de réglage 105 comporte en outre une couronne périphérique 110 comprenant un taraudage intérieur 107. En fonctionnement, le taraudage 107 est en prise sur un filetage complémentaire 109 prévu sur la surface extérieure cylindrique de la paroi extérieure 103 de la cavité 102. En tournant l'organe de réglage 105, on commande donc le déplacement du segment tubulaire 108 le long du tube de décharge 4 pour régler la longueur 1. Ce réglage permet une optimisation supplémentaire du taux d'ondes stationnaires TOS.

Dans un autre mode de réalisation de l'invention, représenté en coupe partielle à la figure 6, la cavité 2 et le guide d'ondes 14 sont montés pivotants l'une par rapport à l'autre autour de l'axe y-y' de l'antenne 16 (non représentée à la figure 6). On peut ainsi régler l'orientation de l'axe x-x' de la cavité 2 et du tube de décharge 4 par rapport à l'axe z-z' du guide d'ondes 14 et réciproquement. Ce réglage d'orientation est avantageux lorsque l'invention est mise en oeuvre dans un procédé industriel où l'encombrement du dispositif continue une contrainte. Dans l'exemple non limitatif illustré à la figure 6, la paroi délimitant le canal 112 faisant communiquer la cavité 2 et le guide d'ondes 14 (analogue à la paroi 11 des figures 1 et 2) se divise en deux parties cylindriques 115, 116 à symétrie de révolution et coaxiales. La partie 115 est solidaire de la paroi extérieure 3 de la cavité 2 et la partie 116 est solidaire du guide d'ondes 14, avec un diamètre intérieur légèrement supérieur au diamètre extérieur de la partie cylindrique 115.

Un palier 119 comportant une surface d'appui 118 perpendiculaire à l'axe de symétrie y-y' est formé à l'angle entre la partie cylindrique 115 et la paroi extérieure 3 de la cavité 2. La partie cylindrique 116 comporte une surface d'appui 117 perpendiculaire à l'axe de symétrie y-y' destinée au contact avec la surface d'appui complémentaire 118. La cavité 2 peut donc pivoter par rapport au guide d'ondes 14 autour de la direction y-y'. Des vis de blocage 120 sont placées dans des orifices taraudés 121 ménagés dans l'épaisseur de la partie cylindrique périphérique 116. Ces vis de blocage 120 s'appuient sur la surface extérieure de la partie cylindrique interne 115 pour bloquer l'orientation du dispositif. Bien entendu de nombreux autres moyens sont envisageables pour assurer le pivotement de la cavité 2 par rapport au guide d'ondes 14 sans sortir du domaine de l'invention.

La présente invention n'est pas limitée aux exemples décrits ci-dessus en référence aux dessins.

L'homme du métier peut bien entendu imaginer de nombreuses variantes sans sortir du domaine de l'invention.

On a fait référence à la valeur de fréquence de 2450 MHz pour les micro-ondes utilisées. Cette fréquence correspond à une norme imposée dans un certain nombre de pays. Il va de soi que l'invention peut être mise en oeuvre pour d'autres valeurs normatives (comme par exemple 915 MHz, 896 MHz ou 433 MHz) ou pour toute valeur dans la gamme des hyperfréquences. Le dimensionnement des composants du dispositif est proportionnel à la longueur d'onde du rayonnement micro-ondes et constitue une opération d'exécution habituelle pour l'homme du métier de la technique concernée.

Il est bien entendu que la décharge produite par le coupleur selon l'invention peut servir à former un plasma de composition chimique quelconque. Les applications préférées de l'invention sont celles nécessitant des plasmas très énergétiques, telles que celles où on exploite les propriétés des plasmas de post-décharge avec un volume utile important.

Dans une autre variante du dispositif selon l'invention, d'autres moyens de refroidissement de la cavité 2 et du tube de décharge 4 sont prévus, notamment si on souhaite produire un plasma de forte puissance pendant un temps long. Ces moyens peuvent comprendre un circuit de refroidissement dans lequel s'écoule un fluide réfrigérant. Ainsi, il est possible de faire circuler de l'eau de refroidissement en contact avec la paroi 3 de la cavité 2. On peut aussi refroidir directement le tube de décharge 4 en le munissant de deux parois en quartz ou analogue, entre lesquelles on fait circuler un fluide réfrigérant ne perturbant pas la propagation des ondes, comme par exemple une huile de silicone.

**Revendications**

1. Dispositif de production d'un plasma froid adapté à transmettre une puissance de plus de 1 kW au plasma par couplage et résonnance forcée d'ondes électromagnétiques hyperfréquences ou micro-ondes ; comprenant une cavité (2 ; 102) délimitée par une paroi extérieure métallique (3 ; 103) et traversée par un tube de décharge (4) dans lequel circule en service un gaz plasmagène ; un générateur d'ondes électromagnétiques hyperfréquences ou de micro-ondes (18) et des moyens de transport des micro-ondes (14, 16 ; 114) entre la sortie du générateur (18) et l'intérieur de la cavité (2 ; 102), les moyens de transport des ondes électromagnétiques hyperfréquences ou des micro-ondes comprenant un guide d'ondes (14 ; 114), un canal (12) débouchant d'une part dans le guide d'ondes (14) et d'autre part dans la cavité (2), et une antenne (16),passant à travers le canal (12), en forme de tige métallique s'étendant entre l'intérieur du guide d'ondes (14 ; 114) et l'intérieur de la cavité (2 ; 102), les directions (X-X' ; Y-Y') suivant lesquelles sont respectivement étendus le tube de décharge (4) et l'antenne (16), et les directions (Y-Y' ; Z-Z') suivant lesquelles sont respectivement étendues l'antenne et le guide d'ondes étant concourrantes.

2. Dispositif conforme à la revendication 1, caractérisé en ce que le gaz plasmagène circulant dans le tube de décharge (4) est exposé aux ondes transmises à l'intérieur de la cavité (2 ; 102) sur une longueur (l) le long du tube de décharge (4) réduite par rapport à la dimension (L) de la cavité (2 ; 102) parallèlement à la direction (X-X') du tube de décharge (4).

3. Dispositif conforme à l'une des revendications 1 ou 2, caractérisé en ce qu'il comprend un segment tubulaire métallique (8 ; 108) situé à l'intérieur de la cavité (2 ; 102) et raccordé à la paroi extérieure (3 ; 103) de la cavité (2 ; 102) autour d'une zone où le tube de décharge (4) traverse la paroi extérieure (3 ; 103) et en ce que ce segment tubulaire (8 ; 108) entoure le tube de décharge (4) sauf en une zone de longueur (l) le long du tube de décharge (4) réduite par rapport à la dimension (L) de la cavité (2 ; 102) parallèlement à la direction (x-x') du tube de décharge (4).

4. Dispositif conforme à la revendication 3, caractérisé en ce que la surface extérieure (8a) du segment tubulaire (8) présente une forme tronconique au voisinage de son extrémité libre (9).

5. Dispositif conforme à l'une des revendications 3 ou 4, caractérisé en ce que le segment tubulaire (108) est monté coulissant dans la direction du tube de décharge (4).

6. Dispositif conforme à la revendication 5, caractérisé en ce que le segment tubulaire (108) est solidaire d'un organe de réglage (105) monté autour du tube de décharge (4) à l'extérieur de la cavité (102), cet organe de réglage (105) comprenant en outre une couronne (110) taraudée intérieurement, le taraudage (107) de la couronne (110) venant en prise sur un filetage complémentaire (109) disposé sur une partie sensiblement cylindrique de la paroi extérieure (103) de la cavité (102), de façon à permettre le coulissement du segment tubulaire (108) le long du tube de décharge (4).

7. Dispositif conforme à l'une des revendications 1 à 6, caractérisé en ce que l'antenne (16) est montée coulissante pour permettre de régler sa longueur de pénétration à l'intérieur de la cavité (2 ; 102).

8. Dispositif conforme à la revendication 7, caractérisé en ce que l'antenne (16) est solidaire d'un organe de réglage (33) comprenant en outre une couronne (34) taraudée intérieurement, le taraudage (41) de la couronne (34) venant en prise sur un filetage complémentaire (40) disposé sur une portion cylindrique (26) solidaire du guide d'ondes (14) et dont l'axe (y-y') coïncide avec l'axe de l'antenne (16).

9. Dispositif conforme à l'une des revendications 1 à 8, caractérisé en ce que l'axe (y-y') de l'antenne (16) est situé à une distance sensiblement égale à $\lambda_G/4$ d'une surface d'extrémité (25 ; 132) du guide d'ondes (14 ; 114), $\lambda_G$ désignant la longueur d'onde des micro-ondes à l'intérieur du guide d'ondes (14 ; 114).

10. Dispositif conforme à l'une des revendications 1 à 9, caractérisé par des moyens (126, 128, 130) pour régler la position d'une surface d'extrémité (132) du guide d'ondes (114) parallèlement à la direction (z-z') du guide d'ondes (114).

11. Dispositif conforme à l'une des revendications 1 à 10, caractérisé en ce que, l'antenne (16) dépassant du guide d'ondes (14) du côté opposé à la cavité (2) dans un passage (28) délimité par une paroi (26) raccordée au guide d'ondes (14), un manchon métallique (30) entoure l'antenne (16) dans ce passage (28), en ce que le manchon (30) est raccordé, en une première extrémité, à une surface (31) formant extrémité du passage (28) et en ce que la distance entre la surface d'extrémité (31) du passage (28) et la seconde extrémité (42) du manchon (30) est égale à $\lambda v/4$, $\lambda v$ désignant la longueur d'onde des micro-ondes dans le vide.

12. Dispositif conforme à la revendication 11, caractérisé en ce que le manchon (30) fait partie d'un organe (29) comprenant en outre une bague (32), l'épaulement entre le manchon (30) et la bague (32) définissant la surface (31) formant extrémité du passage (28).

13. Dispositif conforme à la revendication 12, caractérisé en ce que l'organe (29) est monté dans le passage (28) et bloqué par une câle (36) de façon que la seconde extrémité (42) du manchon (30) soit située sensiblemnt dans le plan défini par la surface (43) du guide d'ondes (14) adjacente au passage (28).

14. Dispositif conforme à l'une des revendications 1 à 13, caractérisé par des moyens (115, 116, 117, 118, 119) pour orienter l'une par rapport à l'autre la direction (x-x') du tube de décharge (4) et la direction (z-z') du guide d'ondes (14).

15. Dispositif conforme à l'une des revendications 1 à 14, caractérisé en ce qu'au moins une des surfaces (6a, 6b, 6c, 8a, 13, 15, 16a, 17, 19, 26, 30, 31, 43) en contact avec les micro-ondes lorsque le dispositif est en fonctionnement comporte une dorure.

16. Dispositif conforme à l'une des revendications 1 à 15, caractérisé en ce qu'il comprend des moyens (10a, 10b) pour refroidir la cavité (2) et le tube de décharge (4) en fonctionnement.

17. Dispositif conforme à la revendication 16, caractérisé en ce que les moyens pour refroidir la cavité (2) et le tube de décharge (4) comprennent un circuit de refroidissement destiné à la circulation d'un fluide réfrigérant.

**18.** Dispositif conforme à la revendication 17, caractérisé en ce que le circuit de refroidissement est en contact avec la paroi (3) de la cavité (2).

**19.** Dispositif conforme à la revendication 17, caractérisé en ce que le dispositif de refroidissement est en contact avec le tube de décharge (4).

## Claims

**1.** A device for producing a cold plasma adapted to transmit a power of more than 1 kW to the plasma through the coupling and forced resonance of electromagnetic waves of ultrahigh frequency or microwave type; comprising a cavity (2 ; 102) delimited by an outer metal wall (3 ; 103) and having a discharge tube (4) passing through it with a plasmagene gas flowing through the latter during operation ; an ultrahigh frequency or microwave type electromagnetic wave generator (18) and means for transmitting microwaves (14, 16 ; 114) between the output of the generator (18) and the interior of the cavity (2 ; 102), the means for transmitting ultrahigh frequency or microwave type electromagnetic waves comprising a waveguide (14 ; 114), a channel (12) opening into the waveguide (14) at one end and into the cavity (2) at the other end, and an antenna (16), passing through the channel (12), shaped like a metal rod extending between the interior of the waveguide (14 ; 114) and the interior of the cavity (2 ; 102), the directions (X-X' ; Y-Y') along which the discharge tube (4) and the antenna (16) are extended, respectively, and the directions (Y-Y' ; Z-Z') along which the antenna and the waveguide are extended, respectively, being concurrent.

**2.** A device in accordance with claim 1, characterised in that the plasmagene gas flowing through the discharge tube (4) is exposed to the waves transmitted inside the cavity (2 ; 102) throughout a length (l) along the discharge tube (4) which is small in comparison with the dimension (L) of the cavity (2 ; 102) parallel to the direction (X-X') of the discharge tube (4).

**3.** A device in accordance with one of claims 1 or 2, characterised in that it comprises a metal tubular segment (8 ; 108) located inside the cavity (2 ; 102) and connected to the outer wall (3 ; 103) of the cavity (2 ; 102) around an area where the discharge tube (4) passes through the outer wall (3 ; 103), and in that this tubular segment (8 ; 108) surrounds the discharge tube (4) except in an area of length (l) along the discharge tube (4) which is small in comparison with the dimension (L) of the cavity (2 ; 102) parallel to the direction (x-x') of the discharge tube (4).

**4.** A device in accordance with claim 3, characterised in that the outer surface (8a) of the tubular segment (8) has a tapered shape near its free end (9).

**5.** A device in accordance with one of claims 3 or 4, characterised in that the tubular segment (108) is mounted so as to slide in the direction of the discharge tube (4).

**6.** A device in accordance with claim 5, characterised in that the tubular segment (108) is integral with an adjusting member (105) mounted around the discharge tube (4) outside of the cavity (102), this adjusting member (105) further comprising a crown (110) with an internal thread, the thread (107) of the crown (110) engaging with a complementary threading (109) arranged on a substantially cylindrical part of the outer wall (103) of the cavity (102), so as to allow the tubular segment (108) to slide along the discharge tube (4).

**7.** A device in accordance with one of claims 1 to 6, characterised in that the antenna (16) is mounted in a sliding fashion so as to make it possible to adjust its length of penetration inside the cavity (2 ; 102).

**8.** A device in accordance with claim 7, characterised in that the antenna (16) is integral with an adjusting member (33) further comprising a crown (34) with an internal thread, the thread (41) of the crown (34) engaging with a complementary threading (40) arranged on a cylindrical portion (26) integral with the waveguide (14) and whose axis (y-y') coincides with the axis of the antenna (16).

**9.** A device in accordance with one of claims 1 to 8, characterised in that the axis (y-y') of the antenna (16) is located at a distance substantially equal to $\lambda G/4$ from an end surface (25 ; 132) of the waveguide (14; 114), $\lambda G$ indicating the wavelength of the microwaves inside the waveguide (14 ; 114).

**10.** A device in accordance with one of claims 1 to 9, characterised by means (126, 128, 130) to adjust the position of an end surface (132) of the waveguide (114) parallel to the direction (z-z') of the waveguide (114).

11. A device in accordance with one of claims 1 to 10, characterised in that, the antenna (16) projecting from the waveguide (14) on the side opposite to the cavity (2) into a passage (28) delimited by a wall (26) connected to the waveguide (14), a metal sleeve (30) surrounds the antenna (16) in this passage (28), in that the sleeve (30) is connected, at a first end, to an end surface (31) of the passage (28), and in that the distance between the end surface (31) of the passage (28) and the second end (42) of the sleeve (30) is equal to λv/4, λv indicating the wavelength of the microwaves in a vacuum.

12. A device in accordance with claim 11, characterised in that the sleeve (30) is part of a member (29) further comprising a ring (32), the shouldering between the sleeve (30) and the ring (32) defining the end surface (31) of the passage (28).

13. A device in accordance with claim 12, characterised in that the member (29) is mounted in the passage (28) and fixed by a shim (36) so that the second end (42) of the sleeve (30) is located substantially on the plane defined by the surface (43) of the waveguide (14) adjacent to the passage (28).

14. A device in accordance with one of claims 1 to 13, characterised by means (115, 116, 117, 118, 119) to orientate the direction (x-x') of the discharge tube (4) and the direction (z-z') of the waveguide (14) with respect to one another.

15. A device in accordance with one of claims 1 to 14, characterised in that at least one of the surfaces (6a, 6b, 6c, 8a, 13, 15, 16a, 17, 19, 26, 30, 31, 43) in contact with the microwaves when the device is operating comprises a gilding.

16. A device in accordance with one of claims 1 to 15, characterised in that it comprises means (10a, 10b) to cool the cavity (2) and the discharge tube (4) during operation.

17. A device in accordance with claim 16, characterised in that the means to cool the cavity (2) and the discharge tube (4) comprise a cooling circuit intended to enable the flow of a cooling fluid.

18. A device in accordance with claim 17, characterised in that the cooling circuit is in contact with the wall (3) of the cavity (2).

19. A device in accordance with claim 17, characterised in that the cooling system is in contact with the discharge tube (4).

## Patentansprüche

1. Erzeugungsvorrichtung eines kalten Plasmas, geeignet zur Übertragung einer Leistung von über 1 kW an das Plasma durch Kupplung und Zwangsresonanz ultrafrequenter elektromagnetischer Wellen oder Mikrowellen; mit einem Hohlraum (2 ; 102), begrenzt von einer externen Metallwand (3 ; 103) und durchquert von einem Entlastungsrohr (4), in dem während des Betriebs ein Plasmidgas umläuft; mit einem Generator von ultrafrequenten elektromagnetischen Wellen oder Mikrowellen (18) und Transportmitteln der Mikrowellen (14, 16 ; 114) zwischen dem Ausgang des Generators (18) und dem Inneren des Hohlraums (2 ; 102), wobei die Transportmittel der ultrafrequenten elektromagnetischen Wellen oder der Mikrowellen einen Wellenleiter (14 ; 114), einen einerseits in den Wellenleiter (14) und andererseits in den Hohlraum (2) mündenden Kanal (12) sowie eine durch den Kanal (12) laufende Antenne (16) in Form eines sich zwischen dem Inneren des Wellenleiters (14 ; 114) und dem Inneren des Hohlraums (2 ; 102) erstreckenden Metallstabs umfassen, wobei sich die Richtungen (X-X' ; Y-Y'), nach denen sich jeweils das Entlastungsrohr (4) und die Antenne (16) erstrecken, und die Richtungen (Y-Y' ; Z-Z'), nach denen sich jeweils die Antenne und der Wellenleiter erstrecken, kreuzen.

2. Vorrichtung nach Anspruch 1, dadurch gekennzeichnet, daß das im Entlastungsrohr (4) umlaufende Plasmidgas den Wellen ausgesetzt ist, die innerhalb des Hohlraums (2 ; 102) über eine Länge (1) entlang dem Entlastungsrohr (4) übertragen werden, die in Bezug auf die Abmessung (L) des Hohlraums (2 ; 102) kleiner ist, die parallel zur Richtung (X-X') des Entlastungsrohrs (4) verläuft.

3. Vorrichtung nach einem der Ansprüche 1 oder 2, dadurch gekennzeichnet, daß sie ein rohrförmiges Metallsegment

EP 0 468 886 B1

(8 ; 108) umfaßt, das innerhalb des Hohlraums (2 ; 102) angeordnet und an die Außenwand (3 ; 103) des Hohlraums (2 ; 102) um eine Zone herum angeschlossen ist, wo das Entlastungsrohr (4) die Außenwand (3 ; 103) durchquert, und daß das rohrförmige Segment (8 ; 108) das Entlastungsrohr (4) umgibt, außer in einer Längenzone (l) entlang dem Entlastungsrohr (4), die in Bezug auf die Dimension (L) des Hohlraums (2 ; 102) kürzer ist, die parallel zur Richtung (x-x') des Entlastungsrohrs (4) verläuft.

4. Vorrichtung nach Anspruch 3, dadurch gekennzeichnet, daß die Außenfläche (8a) des rohrförmigen Segments (8) in der Nachbarschaft seines freien Endes (9) eine Kegelstumpfform aufweist.

5. Vorrichtung nach einem der Ansprüche 3 oder 4, dadurch gekennzeichnet, daß das rohrförmige Segment (108) in Richtung des Entlastungsrohrs (4) gleitend montiert ist.

6. Vorrichtung nach Anspruch 5, dadurch gekennzeichnet, daß das rohrförmige Segment (108) an einem um das Entlastungsorgan (4) herum außerhalb des Hohlraums (102) montierten Einstellorgan (105) befestigt ist, wobei dieses Einstellorgan (105) weiters eine Krone (110) mit Innengewinde umfaßt, wobei das Innengewinde (107) der Krone (110) in ein Gegengewinde (109) einfaßt, das an einem etwa zylindrischen Teil der Außenwand (103) des Hohlraums (102) angeordnet ist, um das Gleiten des rohrförmigen Segments (108) entlang dem Entlastungsrohr (4) zu ermöglichen.

7. Vorrichtung nach einem der Ansprüche 1 bis 6, dadurch gekennzeichnet, daß die Antenne (16) gleitend montiert ist, um die Einstellung ihrer Eindringlänge in den Hohlraum (2 ; 102) hinein zu ermöglichen.

8. Vorrichtung nach Anspruch 7, dadurch gekennzeichnet, daß die Antenne (16) mit einem Einstellorgan (33) verbunden ist, das weiters eine Krone (34) mit Innengewinde umfaßt, wobei das Innengewinde (41) der Krone (34) in ein Gegengewinde (40) einfaßt, das an einem zylindrischen mit dem Wellenleiter (14) verbundenen Abschnitt (26) angeordnet ist, und dessen Achse (y-y') mit der Achse der Antenne (16) zusammentrifft.

9. Vorrichtung nach einem der Ansprüche 1 bis 8, dadurch gekennzeichnet, daß die Achse (y-y') der Antenne (16) in einem Abstand angeordnet ist, der etwa λg/4 einer Endfläche (25 ; 132) des Wellenleiters (14 ; 114) entspricht, wobei λg die Wellenlänge der Mikrowellen innerhalb des Welllenleiters (14 ; 114) bezeichnet.

10. Vorrichtung nach einem der Ansprüche 1 bis 9, gekennzeichnet durch Mittel (126, 128, 130) zur Positionseinstellung einer Endfläche (132) des Wellenleiters (114) parallel zur Richtung (z-z') des Wellenleiters (114).

11. Vorrichtung nach einem der Ansprüche 1 bis 10, dadurch gekennzeichnet, daß, während die Antenne (16) auf der dem Hohlraum (2) gegenüberliegenden Seite den Wellenleiter (14) in einer von einer an den Wellenleiter (14) angeschlossenen Wand (26) begrenzten Passage (28) überragt, die Antenne (16) in dieser Passage (28) von einer Metallmuffe (30) umgeben ist, daß die Muffe (30) an einem ersten Ende an eine das Ende der Passage (28) bildende Fläche (31) angeschlossen ist, und daß der Abstand zwischen der Endfläche (31) der Passage (28) und dem zweiten Ende (42) der Muffe (30) λv/4 entspricht, wobei λv die Wellenlänge der Mikrowellen in der Leere bezeichnet.

12. Vorrichtung nach Anspruch 11, dadurch gekennzeichnet, daß die Muffe (30) Bestandteil eines Organs (29) ist, das weiters einen Ring (32) umfaßt, wobei der Absatz zwischen der Muffe (30) und dem Ring (32) die das Ende der Passage (28) bildende Fläche (31) definiert.

13. Vorrichtung nach Anspruch 12, dadurch gekennzeichnet, daß das organ (29) in der Passage (28) montiert und von einem Keil (36) blockiert ist, so daß sich das zweite Ende (42) der Muffe (30) etwa auf der Ebene befindet, die von der an die Passage (28) angrenzenden Fläche (43) des Wellenleiters (14) definiert wird.

14. Vorrichtung nach einem der Ansprüche 1 bis 13, gekennzeichnet durch Mittel (115, 116, 117, 118, 119) zur gegenseitigen Ausrichtung der Richtung (x-x') des Entlastungsrohrs (4) und der Richtung (z-z') des Wellenleiters (14).

15. Vorrichtung nach einem der Ansprüche 1 bis 14, dadurch gekennzeichnet, daß mindestens eine der während des Betriebs der Vorrichtung mit den Mikrowellen in Kontakt stehenden Flächen (6a, 6b, 6c, 8a, 13, 15, 16a, 17, 19, 26, 30, 31, 43) vergoldet ist.

16. Vorrichtung nach einem der Ansprüche 1 bis 15, dadurch gekennzeichnet, daß sie Mittel (10a, 10b) umfaßt, um den Hohlraum (2) und das Entlastungsrohr (4) während des Betriebs abzukühlen.

17. Vorrichtung nach Anspruch 16, dadurch gekennzeichnet, daß die Mittel zum Abkühlen des Hohlraums (2) und des Entlastungsrohrs (4) einen Kühlkreis für den Umlauf eines Kühlmediums umfassen.

18. Vorrichtung nach Anspruch 17, dadurch gekennzeichnet, daß der Kühlkreis mit der Wand (3) des Hohlraums (2) in Kontakt steht.

19. Vorrichtung nach Anspruch 17, dadurch gekennzeichnet, daß die Kühlvorrichtung mit dem Entlastungsrohr (4) in Kontakt steht.

FIG_1

FIG. 2

FIG_4

130  114

125

z'  z

126  132

128  124

FIG_6

119  y'  3

116  118

117

121

120

115  y  112  114

FIG_3

16

16a

42

29

30

31

32

39

$\dfrac{\lambda_V}{4}$

FIG_5

107  109  103  y'  102

105

106b  106a  106c

108

4

111

x  10a  x

110  11  12

y

14